# FASCICULE DE BREVET EUROPEEN

(11) **EP 4 045 926 B1**
(45) Date de publication et mention de la délivrance du brevet: **25.02.2026**
(21) Numéro de dépôt: 20820259.8
(22) Date de dépôt: 18.09.2020
(51) Int. Cl.: G01R 31/389

(54) **PROCEDE DE DETERMINATION D'UN ETAT D'UNE BATTERIE D'UN VEHICULE AUTOMOBILE**
VERFAHREN ZUR ERMITTLUNG EINES ZUSTANDS EINER KRAFTFAHRZEUGBATTERIE
METHOD FOR DETERMINING A STATE OF A MOTOR VEHICLE BATTERY

(30) Priorité: 16.10.2019 FR 1911502
(43) Date de publication de la demande: 24.08.2022
(73) Titulaire: Stellantis Auto SAS, 78300 Poissy (FR)
(72) Inventeur: MANSOURI, Abdelkader, 78800 HOUILLES (FR); CHEMISKY, Jean Pierre, 92150 SURESNES (FR); MORNET, Mickael, 78330 FONTENAY LE FLEURY (FR)
(74) Mandataire: PSIP
(86) Numéro de dépôt international: PCT/FR2020/051611
(87) Numéro de publication internationale: WO 2021/074495

(56) Documents cités:
- JP-A- 2002 097 974
- US-A- 4 697 134
- US-A- 5 831 435

## Description

La présente invention revendique la priorité de la demande française N°1911502 déposée le 16.10.2019.

La présente invention concerne un procédé de détermination d'un état d'une batterie équipant un véhicule automobile.

Un véhicule automobile est couramment équipé d'une batterie, telle qu'une batterie 12V, notamment une batterie au plomb, pour alimenter en électricité des accessoires du véhicule automobile. Il est nécessaire de connaître un état de la batterie pour notamment pourvoir à son remplacement en cas de défaillance de la batterie. On comprend qu'un tel état est relatif à un état de santé, un état d'usure ou analogue qui indique des performances de la batterie.

On connait des procédés de détermination de l'état de la batterie qui font appel à des capteurs de mesure, notamment de température, voire des charges électriques additionnelles pour obtenir un courant d'une intensité suffisamment importante, notamment de l'ordre de 70 A. Dans ce dernier cas, cela nécessite aussi l'implantation d'au moins un interrupteur. On pourra par exemple se reporter aux documents DE102007061112 et DE102009038663 qui décrivent des procédés du genre susvisés qui nécessitent une implantation d'éléments qui encombrent et alourdissent le véhicule automobile

On connait en outre du document de brevet JP-A-2002097974 un procédé selon le préambule de la revendication 1.

Un but de la présente invention est de proposer un procédé de détermination d'un état d'une batterie équipant un véhicule automobile, qui est simple et rapide à mettre en œuvre, le procédé ne nécessitant pas d'implanter sur le véhicule automobile des éléments alourdissant et encombrant le véhicule automobile.

Dans sa généralité, un procédé de la présente invention est un procédé dans lequel on détermine un état de santé d'une batterie à partir d'une analyse d'une résistance interne de la batterie et d'une chute de tension d'un appel de courant. L'état de santé de la batterie est évalué par rapport à sa capacité à répondre à des prestations véhicules en l'occurrence des appels de courant d'organes sécuritaires du véhicule automobile, tels qu'une direction assistée (DAE), un correcteur électronique de trajectoire (ESP) ou analogue.

Plus particulièrement, un procédé de la présente invention est un procédé de détermination d'un état d'une première batterie équipant un véhicule automobile. Le véhicule automobile est pourvu d'une chaîne de traction hybride comprenant au moins un moteur à combustion interne et une boîte de vitesses comportant une machine électrique reliée à un premier convertisseur. Le premier convertisseur est en relation avec un alterno-démarreur par l'intermédiaire d'un circuit électrique. Le véhicule automobile est pourvu d'une deuxième batterie reliée à un deuxième convertisseur.

Selon la présente invention, le procédé de détermination comprend :
- une première étape qui consiste à configurer le deuxième convertisseur en mode réversibilité et activer une charge 48 V équipant le véhicule automobile, la première étape étant postérieure à un démarrage du véhicule automobile, ou la première étape étant antérieure à un démarrage du véhicule automobile,
- une deuxième étape qui consiste à appliquer une tension de 48 V à la première batterie à partir de la charge 48 V,
- une troisième étape qui consiste à mesurer une tension de batterie aux bornes de la première batterie durant un appel de courant pour en déduire une résistance interne de la première batterie,
- une quatrième étape qui consiste à comparer la résistance interne mesurée à une résistance-seuil,
- une cinquième étape qui consiste à afficher une information d'alerte pour un utilisateur du véhicule automobile, si la résistance interne mesurée est supérieure à la résistance-seuil,
- une sixième étape qui consiste à déconnecter la charge 48 V et rétablir un démarrage normal, si la résistance interne mesurée est inférieure ou égale à la résistance-seuil Le procédé de détermination comprend avantageusement l'une quelconque au moins des caractéristiques suivantes prises seules ou en combinaison :
   - la charge 48 V est constituée de la deuxième batterie,
   - la charge 48 V est constituée de l'alterno-démarreur,
   - la charge 48 V est constituée de la machine électrique,
   - la première batterie est une batterie 12 V,
   - si la première étape est antérieure à un démarrage du véhicule automobile, alors le démarrage du véhicule automobile est réalisé entre la première étape et la deuxième étape,
   - le deuxième convertisseur est monté en parallèle de l'alterno-démarreur,
   - la première batterie et la deuxième batterie sont montées en parallèle du deuxième convertisseur.

On comprend que le procédé de la présente invention est un procédé de détermination d'un état d'une batterie équipant un véhicule automobile qui met avantageusement en œuvre des éléments constitutifs d'une chaîne de traction hybride et/ou d'une architecture de façade équipant le véhicule automobile pour déterminer l'état de la batterie.

Plus particulièrement, le procédé de détermination de la présente invention exploite des charges 48 V équipant le véhicule automobile pour réaliser un appel de courant et un diagnostic de l'état d'une batterie à tester, telle que la batterie 12 V susvisée. L'invention sera mieux comprise à la lecture de la description non limitative qui suit, rédigée au regard des dessins annexés, dans lesquels :
[Fig. 1] - la figure 1 représente schématiquement une chaîne de traction hybride et une architecture de façade équipant un véhicule automobile pourvue d'une première batterie dont un état est à tester,
[Fig. 2] - la figure 2 représente schématiquement une première variante d'un procédé de détermination d'un état de la première batterie illustrée sur la figure 1,
[Fig. 3] - la figure 3 représente schématiquement une deuxième variante d'un procédé de détermination d'un état de la première batterie illustrée sur la figure 1.

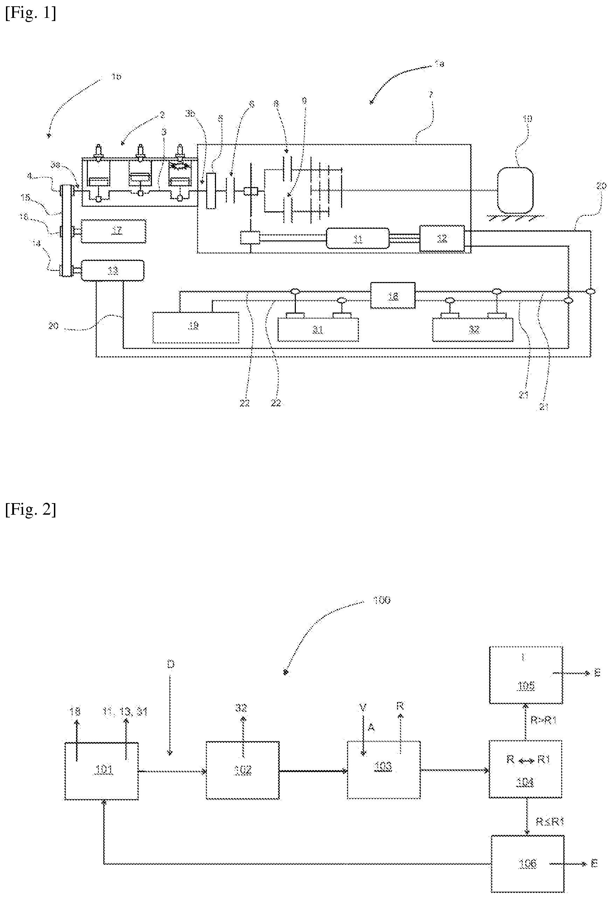

La figure 1 représente schématiquement une chaîne de traction hybride 1a et une architecture de façade 1b équipant un véhicule automobile qui sont avantageusement mises à profit pour déterminer un état d'une première batterie 31 par l'intermédiaire d'un procédé de la présente invention. On comprend que la chaîne de traction hybride 1a et l'architecture de façade 1b sont connues en soi mais comprennent des éléments qui sont avantageusement utilisés pour tester la première batterie 31 et déterminer son état, couramment dénommé « état de santé ».

La chaîne de traction hybride 1a comprend notamment un moteur à combustion interne 2 qui est associé à un vilebrequin 3. Le vilebrequin 3 comprend une première extrémité 3a pourvue d'une première poulie 4 et une deuxième extrémité 3b équipée d'un volant-moteur 5. Le volant-moteur 5 est en relation avec un premier embrayage 6 d'une boîte de vitesses 7 qui comprend un deuxième embrayage 8 et un troisième embrayage 9 pouvant être sélectivement accouplés à des roues 10.

La boîte de vitesses 7 comprend une machine électrique 11, tel qu'un moteur électrique 48 V, relié à un premier convertisseur 12, tel qu'un convertisseur courant alternatif / courant continu, couramment dénommé convertisseur AC/ DC, qui est lui-même en relation avec un alterno-démarreur 13, tel qu'un alterno-démarreur 48 V, par l'intermédiaire d'un circuit électrique 20. L'alterno-démarreur 13 est pourvue d'une deuxième poulie 14. La première poulie 4 et la deuxième poulie 14 sont reliées l'une à l'autre par une courroie 15 qui est aussi en relation avec une troisième poulie 16, telle que celle d'un compresseur de climatisation 17 ou analogue. Les poulies 4, 14, 16 et la courroie 15 sont notamment constitutives de l'architecture de façade 1b du véhicule automobile.

Une première branche électrique 21 est montée en parallèle de l'alterno-démarreur 13 sur le circuit électrique 21. La première branche électrique 21 comprend un deuxième convertisseur 18, tel qu'un convertisseur courant continu / courant continu, couramment dénommé convertisseur DC /DC. Le deuxième convertisseur 18 est également constitutif d'une deuxième branche électrique 22 équipée d'au moins un dispositif électrique 19 du véhicule automobile. Sur la première branche électrique 21, est montée en parallèle du deuxième convertisseur 18 une deuxième batterie 32, telle qu'une batterie Li-ion, notamment de 48 Volts. Sur la deuxième branche électrique 22, est montée en parallèle du deuxième convertisseur 18 la première batterie 31, telle qu'une batterie au plomb, notamment de 12 Volts. La première batterie 31 est la batterie dont l'état de santé est à déterminer.

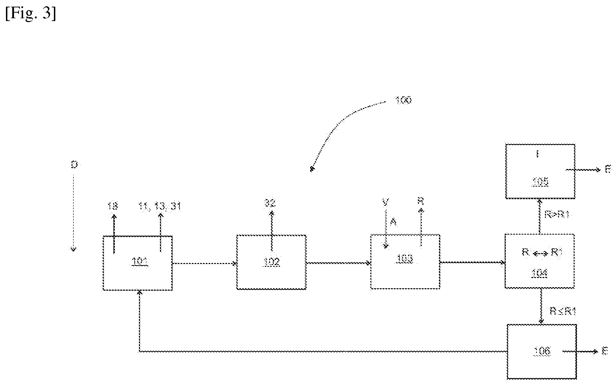

Sur les figures 2 et 3, un procédé de détermination 100 d'un état E d'une batterie à tester, telle que ladite première batterie 31, autrement dit la batterie 12 V au plomb, est représenté.

Le procédé de détermination 100 comprend une première étape 101 qui consiste à configurer le deuxième convertisseur 18 en mode réversibilité et activer une charge 48 V équipant le véhicule automobile. On comprend que la charge 48 V est indifféremment constituée de la deuxième batterie 32, de la machine électrique 11 ou de l'alterno-démarreur 13.

Le procédé de détermination 100 comprend une deuxième étape 102 qui consiste à solliciter la première batterie 31 en lui appliquant une tension de 48 V à partir de la charge 48 V.

Le procédé de détermination 100 comprend une troisième étape 103 qui consiste à mesurer une tension de batterie V aux bornes de la première batterie 31 durant un appel de courant A pour en déduire une résistance interne R de la première batterie 31. La résistance interne R ainsi mesurée reflète l'état E de la première batterie 31.

Le procédé de détermination 100 comprend une quatrième étape 104 qui consiste à comparer la résistance interne mesurée R à une résistance-seuil R1.

Si la résistance interne mesurée R est supérieure à la résistance-seuil R1, le procédé de détermination 100 comprend une cinquième étape 105 qui consiste à afficher une information d'alerte I pour l'utilisateur du véhicule automobile. L'information d'alerte I est par exemple un allumage d'un voyant électrique. Accessoirement, un démarrage du véhicule automobile est interdit.

Si la résistance interne mesurée R est inférieure ou égale à la résistance-seuil R1, aucune information d'alerte n'est affichée et le procédé de détermination 100 comprend une sixième étape 106 qui consiste à déconnecter la charge de 48 V et rétablir un démarrage normal.

Selon une première variante illustrée sur la figure 2, la première étape 101 est réalisée avant un démarrage D du véhicule automobile.

Selon une deuxième variante illustrée sur la figure 3, la première étape 101 est réalisée immédiatement après un démarrage D du véhicule automobile. On comprend qu'un laps de temps de l'ordre de quelques centaines de millisecondes s'écoule entre le démarrage D et la première étape 101.

## Revendications

1. Procédé de détermination (100) d'un état (E) d'une première batterie (31) équipant un véhicule automobile, le véhicule automobile étant pourvu d'une chaîne de traction hybride (1a) comprenant au moins un moteur à combustion interne (2) et une boîte de vitesses (7) comportant une machine électrique (11) reliée à un premier convertisseur (12), le premier convertisseur (12) étant en relation avec un alterno-démarreur (13) par l'intermédiaire d'un circuit électrique (20), le véhicule automobile étant pourvu d'une deuxième batterie (32) reliée à un deuxième convertisseur (18), le procédé de détermination (100) comprenant :
- une deuxième étape (102) qui consiste à appliquer une tension de 48 V à la première batterie (31) à partir de la charge 48 V (11, 13, 32),
- une troisième étape (103) qui consiste à mesurer une tension de batterie (V) aux bornes de la première batterie (31) durant un appel de courant (A) pour en déduire une résistance interne (R) de la première batterie (31),
- une quatrième étape (104) qui consiste à comparer la résistance interne mesurée (R) à une résistance-seuil (R1),
- une cinquième étape (105) qui consiste à afficher une information d'alerte (I) pour un utilisateur du véhicule automobile, si la résistance interne mesurée (R) est supérieure à la résistance-seuil (R1),
- une sixième étape (106) qui consiste à déconnecter la charge 48 V (11, 13, 32) et rétablir un démarrage normal, si la résistance interne mesurée (R) est inférieure ou égale à la résistance-seuil (R1),
**caractérisé en ce qu'**il comprend :
- une première étape (101) qui consiste à configurer le deuxième convertisseur (18) en mode réversibilité et activer une charge 48 V (11, 13, 32) équipant le véhicule automobile, la première étape (101) étant postérieure à un démarrage (D) du véhicule automobile, ou la première étape (101) étant antérieure à un démarrage (D) du véhicule automobile.

2. Procédé de détermination (100) selon la revendication 1, **caractérisé en ce que** la charge 48 V (11, 13, 32) est constituée de la deuxième batterie (32).

3. Procédé de détermination (100) selon la revendication 1, **caractérisé en ce que** la charge 48 V (11, 13, 32) est constituée de l'alterno-démarreur (13).

4. Procédé de détermination (100) selon la revendication 1, **caractérisé en ce que** la charge 48 V (11, 13, 32) est constituée de la machine électrique (11).

5. Procédé de détermination (100) selon l'une quelconque des revendications précédentes, **caractérisé en ce que** la première batterie (31) est une batterie 12 V.

6. Procédé de détermination (100) selon l'une quelconque des revendications précédentes, **caractérisé en ce que** si la première étape (101) est antérieure à un démarrage (D) du véhicule automobile, le démarrage (D) du véhicule automobile est réalisé entre la première étape (101) et la deuxième étape (102).

7. Procédé de détermination (100) selon l'une quelconque des revendications précédentes, **caractérisé en ce que** le deuxième convertisseur (18) est monté en parallèle de l'alterno-démarreur (13).

8. Procédé de détermination (100) selon l'une quelconque des revendications précédentes, **caractérisé en ce que** la première batterie (31) et la deuxième batterie (32) sont montées en parallèle du deuxième convertisseur (18).

## Patentansprüche

1. Verfahren (100) zur Bestimmung des Zustands (E) einer ersten Batterie (31) in einem Kraftfahrzeug, wobei das Kraftfahrzeug mit einem Hybridantrieb (1a) ausgestattet ist, der mindestens einen Verbrennungsmotor (2) und ein Getriebe (7) mit einer Elektromotormaschine (11) umfasst, die mit einem ersten Wandler (12) verbunden ist. Der erste Wandler (12) ist über einen Stromkreis (20) mit einem Startergenerator (13) verbunden. Das Kraftfahrzeug ist mit einer zweiten Batterie (32) ausgestattet, die mit einem zweiten Wandler (18) verbunden ist. Das Bestimmungsverfahren (100) umfasst: - einen zweiten Schritt (102), bei dem eine Spannung von 48 V an die erste Batterie (31) von der 48-V-Last (11, 13, 32) angelegt wird; - einen dritten Schritt (103), bei dem die Batteriespannung (V) an den Anschlüssen der ersten Batterie (31) während einer Stromaufnahme (A) gemessen wird, um den Innenwiderstand (R) der ersten Batterie (31) zu bestimmen; - einen vierten Schritt (104) Vergleich des gemessenen Innenwiderstands (R) mit einem Schwellenwertwiderstand (R1), - fünfter Schritt (105) Anzeige einer Warnmeldung (I) für den Fahrzeugnutzer, falls der gemessene Innenwiderstand (R) den Schwellenwertwiderstand (R1) überschreitet, sechster Schritt (106) Trennung der 48-V-Last (11, 13, 32) und Wiederherstellung eines normalen Startvorgangs, falls der gemessene Innenwiderstand (R) kleiner oder gleich dem Schwellenwertwiderstand (R1) ist, charakterisiert durch: - ersten Schritt (101) Konfiguration des zweiten Wandlers (18) im Reversibilitätsmodus und Aktivierung einer im Kraftfahrzeug verbauten 48-V-Last (11, 13, 32), wobei der erste Schritt (101) entweder nach oder vor dem Startvorgang (D) des Kraftfahrzeugs erfolgt.

2. Verfahren zur Bestimmung (100) nach Anspruch 1, **dadurch gekennzeichnet, dass** die 48-V-Last (11, 13, 32) aus der zweiten Batterie (32) besteht.

3. Verfahren zur Bestimmung (100) nach Anspruch 1, **dadurch gekennzeichnet, dass** die 48-V-Last (11, 13, 32) aus dem Anlassergenerator (13) besteht.

4. Verfahren zur Bestimmung (100) nach Anspruch 1, **dadurch gekennzeichnet, dass** die 48-V-Last (11, 13, 32) aus der elektrischen Maschine (11) besteht.

5. Verfahren zur Bestimmung (100) nach einem der vorhergehenden Ansprüche, **dadurch gekennzeichnet, dass** die erste Batterie (31) eine 12-V-Batterie ist.

6. Verfahren zur Bestimmung (100) nach einem der vorhergehenden Ansprüche, **dadurch gekennzeichnet, dass**, wenn der erste Schritt (101) dem Starten (D) des Kraftfahrzeugs vorausgeht, das Starten (D) des Kraftfahrzeugs zwischen dem ersten Schritt (101) und dem zweiten Schritt (102) erfolgt.

7. Verfahren zur Bestimmung (100) nach einem der vorhergehenden Ansprüche, **dadurch gekennzeichnet, dass** der zweite Wandler (18) parallel zum Anlassergenerator (13) geschaltet ist.

8. Verfahren zur Bestimmung (100) nach einem der vorhergehenden Ansprüche, **dadurch gekennzeichnet, dass** die erste Batterie (31) und die zweite Batterie (32) parallel zum zweiten Wandler (18) geschaltet sind.

## Claims

1. Method for determining (100) the state (E) of a first battery (31) equipping a motor vehicle, the motor vehicle being equipped with a hybrid powertrain (1a) comprising at least one internal combustion engine (2) and a gearbox (7) including an electric machine (11) connected to a first converter (12), the first converter (12) being connected to a starter-alternator (13) via an electrical circuit (20), the motor vehicle being equipped with a second battery (32) connected to a second converter (18), the determination method (100) comprising: - a second step (102) which consists of applying a voltage of 48 V to the first battery (31) from the 48 V load (11, 13, 32), - a third step (103) which consists of measuring a battery voltage (V) across the terminals of the first battery (31) during a current draw (A) to deduce an internal resistance (R) of the first battery (31), - a fourth step (104) which consists of comparing the measured internal resistance (R) to a threshold resistance (R1), - a fifth step (105) which consists of displaying a warning message (I) to a user of the motor vehicle, if the measured internal resistance (R) is greater than the threshold resistance (R1), - a sixth step (106) which consists of disconnecting the 48 V load (11, 13, 32) and restoring a normal start, if the measured internal resistance (R) is less than or equal to the threshold resistance (R1), **characterized in that** it comprises: - a first step (101) which consists of configuring the second converter (18) in reversibility mode and activating a 48 V load (11, 13, 32) fitted to the motor vehicle, the first step (101) being subsequent to a start (D) of the vehicle automobile, or the first step (101) being prior to a starting (D) of the motor vehicle.

2. A method of determination (100) according to claim 1, **characterized in that** the 48 V load (11, 13, 32) consists of the second battery (32).

3. A method of determination (100) according to claim 1, **characterized in that** the 48 V load (11, 13, 32) consists of the alternator-starter (13).

4. A method of determination (100) according to claim 1, **characterized in that** the 48 V load (11, 13, 32) consists of the electric machine (11).

5. A method for determining (100) according to any one of the preceding claims, **characterized in that** the first battery (31) is a 12 V battery.

6. A method for determining (100) according to any one of the preceding claims, **characterized in that** if the first step (101) precedes a starting (D) of the motor vehicle, the starting (D) of the motor vehicle is carried out between the first step (101) and the second step (102).

7. A method for determining (100) according to any one of the preceding claims, **characterized in that** the second converter (18) is mounted in parallel with the alternator-starter (13).

8. A method for determining (100) according to any one of the preceding claims, **characterized in that** the first battery (31) and the second battery (32) are mounted in parallel with the second converter (18).
